Europäisches Patentamt

European Patent Office

Office européen des brevets

(11) Publication number: **0 385 736**
**A2**

# EUROPEAN PATENT APPLICATION

(21) Application number: 90302097.2

(22) Date of filing: 27.02.90

(51) Int. Cl.5: **H01L 23/29, C08L 63/00**

(30) Priority: 02.03.89 US 318092

(43) Date of publication of application:
05.09.90 Bulletin 90/36

(34) Designated Contracting States:
AT BE CH DE DK ES FR GB GR IT LI LU NL SE

(71) Applicant: **ROHM AND HAAS COMPANY**
**Independence Mall West**
**Philadelphia Pennsylvania 19105(US)**

(72) Inventor: **Peterson, James Oliver**
**16 Brookdale Drive**
**New Britain, Pennsylvania 18901(US)**
Inventor: **Naik, Rajiv Harshadrai**
**111 Claremont Drive**
**Lansdale, Pennsylvania 19446(US)**
Inventor: **Linden, Gary Lee**
**3148 Princeton Road,**
**Greensburg, Pennsylvania 15601(US)**

(74) Representative: **Tanner, James Percival et al**
**ROHM AND HAAS (UK) LTD. European**
**Operations Patent Department Lennig House**
**2 Mason's Avenue**
**Croydon, Surrey, CR9 3NB(GB)**

(54) Epoxy encapsulant compositions and low stress additive systems therefor.

(57) A low stress additive system for epoxy encapsulants, and low stress epoxy encapsulants containing the low stress additive system are disclosed. The low stress additive system comprises composite organic polymer particles and liquid silicon-containing compounds, such as organopolysiloxanes. The epoxy encapsulants prepared with the low stress additive system display low stress, good flow, and do not exhibit excess resin bleed.

EP 0 385 736 A2

## EPOXY ENCAPSULANT COMPOSITIONS AND LOW STRESS ADDITIVE SYSTEMS THEREFORE

The present invention is concerned with additive systems for epoxy molding compositions, with epoxy molding compositions containing such additive systems and suitable for use as encapsulants for electrical and electronic devices, particularly for microelectronic components such as semiconductors, and with electronic devices encapsulated in such epoxy molding compositions.

The tremendous progress in the microelectronics industry has enabled the production of semiconductor chips of increasing size, functionality, complexity and circuit density. Such large semiconductor chips are vulnerable to damage due to stresses such as thermally induced internal stress during operation, and the stress that is generated during cure of the encapsulant composition. This presents a severe challenge to the encapsulant composition.

Electrical and electronic devices have been encapsulated in a variety of resinous materials, including epoxy, silicone and phenolic materials. Thus, it is known to provide epoxy resinous molding compositions which comprise epoxy resin, hardener therefor and inorganic filler as the essential ingredients thereof, to which various adjuvants such as catalysts, mold release agents, pigments, flame retardants and coupling agents may be added.

Various attempts have been made to include rubbery materials in epoxy molding compositions to relieve internal stress.

Epoxy compositions have been disclosed that contain silicone rubbers and/or silicone polymer particles in epoxy compositions along with liquid silicon-containing compounds, for example, in JP-A-62062811; JP-A-62050325; and JP-A-62192447.

Epoxy compositions have been disclosed that contain organopolysiloxanes and/or silicone oils along with synthetic rubber particles, including polybutadiene rubber particles, for example, in JP-A-60206824; JP-A-61026654; JP-A-62192442; and JP-A-59094442.

Epoxy compositions have been disclosed that contain composite particles having a diene rubber core, for example, in JP-A-62022825; JP-A-62022849; JP-A-62022850; and JP-A-61029351. We have found, however, that the use of composite organic polymer particles alone produces loss in flowability of the epoxy composition, as for example, spiral flow.

Resin bleed is the loss of molding composition during the molding process due to material flowing out of the mold through small openings for example at the mold seams. In this situation the molding composition may escape and coat the lead frame, which is undesirable because this material must be removed from the lead frame; adding an additional process step. In Kras flash and bleed tests, which are described in more detail hereinafter, the term resin bleed is used to describe the flow of material into the channels of smaller dimensions, for example the 0.025, 0.013 and 0.0064mm (1.0, 0.5 and 0.25 mil) deep channels. The term flash is used to describe flow into the deeper channels [0.051 and 0.076 mm (2.0 and 3.0 mils)].

The present invention enables the provision of an epoxy encapsulant composition that cures to provide a coating or capsule that resists damage to the encapsulated device due to internal stress of the encapsulant composition, such an epoxy composition that does not produce an excessive degree of resin bleed and exhibits good spiral flow so that it will fill the mold cavity, and encapsulated electronic devices that are more resistant to failure and improved electronic equipment that contain the encapsulated devices.

According to the present invention there is provided a low stress additive system for lowering the internal stress of epoxy molding compositions, which comprises:

(a) an amount of composite oganic polyiner particles effective to provide the desired reduction of the internal stress of the cured epoxy molding composition, the composite organic polymer prarticles having a soft rubbery core of organic polymer and at least one shell of harder organic polymer; and

(b) an amount of liquid silicon-containing compound, other than silane coupling agents, effective to maintain flowability of the epoxy without causing substantially increased resin bleed.

The present invention also provides epoxy molding compositions comprising the low stress additive system.

The epoxy composition of the invention exhibits the desirable combination of properties of low stress, low resin bleed, low flash and long flow during molding. These compositions are useful for example to encapsulate microelectronic devices, particularly semiconductor chips. The desirable combination of properties makes this material suitable for the encapsulation of large complex chips. The invention thus allows the large scale production of chips that are more resistant to failure caused by internal stress of the encapsulant composition, and without excessive resin bleed or flash during molding. This, in turn, provides a more reliable electronic device and improves the reliability of electronic equipment that contains the device.

The low stress additive system is present in the epoxy composition in an amount effective to lower the stress of the epoxy formulation, and the relative amounts of the components of the system are selected to provide the desired molding properties of a low degree of resin bleed and flash along with the flow properties necessary to fill the mould before the onset of cure.

The composite, or sequential, organic polymer particles useful in the invention have a soft rubbery "core" of organic polymer and at least one layer or shell of a harder organic polymer. Various composite organic polymer particles having a rubbery polymeric core are known and are commercially available. Composite particles having multiple layers, or sequential stages, such as the MBS(Methacrylate/ Butadiene/ Styrene) modifiers are a preferred type of composite particles for use in the invention. These particles can be prepared by known means such as the methods disclosed in US-A-3,761,455 and US-A-3,775,514, which disclosures are herein incorporated by reference. These particles are commonly available as a dry powder.

For example, the MBS modifiers may, according to the procedure of US-A-3775514, be produced by preparing a latex of butadiene polymer by polymerization of butadiene, or a mixture of butadiene and styrene, in the presence of a small amount of a divinyl crosslinking agent, and then adding, to the latex, styrene and methylmethacrylate monomers and a small amount of a divinyl crosslinking agent copolymerizable with the monomers. The styrene and methylmethacrylate are added by firstly adding the styrene and a portion of the methylmethacrylate to the latex in a first graft polymerization stage and then adding the remainder of the methylmethacrylate in a second graft polymerization stage when the greater part of the first polymerization is completed.

The composite polymer particles are generally present in amounts from greater than about 0.1 to about 20 weight percent, based on the total epoxy composition. Usually the amount of composite polymer particles is from about 0.5 to about 10 weight percent, based on the total composition. A preferred amount is from about 1 to about 5 weight percent, based on the total composition.

The term "liquid silicon-containing compound", as used in the specification and claims, includes materials that are known in the art and can generally be described as polymeric fluids, typically represented in chemical structures as chains made up of repeating units of silicon atoms and connecting atoms, such as oxygen. These fluids can be linear or branched. The valences of the silicon atoms that do not connect directly or indirectly to another silicon atom in the chain are bonded, directly or indirectly, to functional groups such as hydrogen, alkyl, alkoxyl, aryl, arylalkyl, and aryloxyl groups. Examples of indirect attachment of the functional group to the silicon atom are the so-called "side chains" of non-silicon atoms such as polyalkyleneoxides, typically polyethylene- and/or polypropylene-oxides that are present in organo-silicon surfactants. The term "liquid silicon-containing compounds" is to be read to specifically exclude the silane coupling agents, which, if present in the epoxy molding composition, do not form a part of the low stress additive system. Both the molecular weight and degree of branching of the liquid silicon-containing compound have an effect on the viscosity of the liquid silicon-containing compound; to be useful in the invention the liquid silicon-containing compound must have a viscosity such that it serves to enhance rather than retard the flow of the composition.

Organopolysiloxanes are the preferred liquid silicon-containing compounds. Specific examples of these materials include alkoxy functional polysiloxanes, such as Dow Corning Q1-3074 and Dow Corning X-3037, which are described in product literature as methoxy functional low molecular weight silicone reactive intermediates, and General Electric G.E. SR-193 and G.E. SR-191; and the silicone surfactants, such as Silwet L-7500, available from Union Carbide Corporation, which is described in product literature as non-ionic polyalkyleneoxide-modified dimethylpolysiloxanes. Mixtures of more than one silicon-containing liquid can be used in the low stress additive system.

The liquid silicon-containing compound is present in an amount effective to offset the loss of flow properties that would occur if the composite polymer particles were added alone, but not exceeding an amount that would cause an unacceptable degree of resin bleed. It is recommended that, when attempting to modify a given formulation, the amount of composite polymer particles that produce the desired degree of stress reduction should first be established. The amount of liquid silicon-containing compound necessary to improve the flow properties of the composite polymer particle-modified formulation, without causing an elevated degree of resin bleed, can then be determined, for example in a ladder set of experiments starting with a small amount of liquid silicon-containing compound, preferably 0.3 weight percent, based on the total formulation, and increasing the amount gradually, for example in steps of 0.2%. The formulator is advised to continue increasing the amount of liquid silicon-containing compound until the desired flow properties, especially spiral flow, are achieved; and is cautioned not to discontinue the ladder experiments in the face of poor resin bleed performance at low levels of the liquid silicon-containing compound, since the low stress additive system may surprisingly display reduced resin bleed when a higher content of liquid silicon-containing compound is used after initial poor resin bleed at low levels. This finding was contrary to what we expected due to earlier findings with epoxy formulations modified with the liquid silicon-containing compound alone, in which increased levels of silicon-containing liquid generally increased the resin bleed.

The amount of liquid silicon-containing compound will vary with the amount of composite particles. Generally this amount is from about 0.1 percent to about 10 percent by weight, based on the weight of the total epoxy composition.

Epoxy resins suitable for use in the epoxy compositions of the present invention are those having more than one epoxide group and may be any of those used in molding compositions, such as the diglycidyl ethers of bisphenol A, glycidyl ethers of phenol-formaldehyde resins, or aliphatic, cycloaliphatic, aromatic or heterocyclic epoxies. These epoxy resins include those commercially available under a variety of trademarks, such as "Epon" (available from Shell), "Epi-Rez"(available from Interez), and "Araldite" (available from Ciba-Geigy), to name a few. Epoxylated novolac resins are also useful in this invention and include those available commercially under the trademarks "Ciba ECN"and "Dow DEN". The epoxy resins disclosed in US-A- 4,042,550 are useful in the practice of this invention. Epoxidized cresol novolac resins are preferred and include those commercially available from Sumitomo ("Sumi-epoxy"), Dow Chemical Company ("Quatrex"), Tohto Kasei ("Epo Tohto"), Dainippon Inks and Chemicals ("Epiclon"). The epoxy is usually present in an amount from about 5 to about 80, and preferably from about 10 to about 65, percent resin by weight of finished composition. From this it is to be understood that the resin may be a polymeric or polymerizable mixture containing an epoxy component in significant quantity, e.g., in excess of 20 weight percent of the resin mixture.

Hardeners, also known as curing agents, may be used in the epoxy composition and include any of those commonly used for the purpose of cross-linking the epoxy resin and causing it to form a hard and infusible mass. Such hardeners are well known in the art and the use of any particular one, or combination thereof, is not critical to the present invention. Hardeners, or curing agents, which may be used include the following:

1) Any cyclic anhydride of a dicarboxylic or other polycarboxylic acid suitable for crosslinking the epoxy resin at cure temperatures. These include, but are not limited to, the following: phthalic anhydride, tetrachlorophthalic anhydride, benzophenonetetracarboxylic dianhydride (BTDA), pyromellitic dianhydride (PMDA), the dianhydride of 1,2,3,4-cyclopentanetetracarboxylic acid (CPDA), trimellitic anhydride, trimellitic double anhydride, nadic anhydride (i.e., endomethylene tetrahydrophthalic anhydride), chlorendic anhydride, hexahydrophthalic anhydride, and the like. Other useful anhydride curing agents are those available under the trademark "AMOCO", e.g., Amoco TMX 220 which is apparently the reaction product of trimellitic acid with the diacetic acid derivative of ethylene glycol, and Amoco TMX 330 which is the reaction product of triacetin with trimellitic anhydride.

2) Cresol or phenol novolacs are useful as hardener and are formed by reacting formaldehyde with cresols or with phenols to form condensates containing phenolic hydroxyl groups. Other resinous materials that contain hydroxyl functional aromatic groups may also be useful.

3) Any of the polyamines which are commonly used as hardeners may be used as the hardener, for example, the diamines, including aromatic amines represented by methylene dianiline, m-phenylene diamine, and m-tolylene diamine.

Generally, from about 10 to about 200%, preferably from about 20% to 100%, ofhardener, based on the stoichiometric amount of the epoxy group employed, is used.

A variety of adjuvants may be added, to the epoxy molding composition to provide special properties. Thus, fillers such as fused silica and Aerosil R-972, catalysts, mold release agents, pigments, flame retardants, and/or coupling agents may be employed in addition to the epoxy resin, additive system and optional hardener.

A catalyst functions to accelerate the rate of cure or hardening of the epoxy resin. Thus, although not essential to the hardening of the epoxy resin per se, a catalyst is useful commercially on a production basis as it shortens the length of time necessary to bring about the thermoset condition of the molding composition. Some catalysts which have been used are: amines, such as dimethylamine, benzyldimethylamine, and dimethylaminoethylphenol; metal halides such as boron trifluoride, zinc chloride, stannic chloride, and the like; phosphines, such as triphenylphosphine; acetylacetonates and a variety of imidazoles. When present, the catalyst may, for example, be present in an amount of from about 0.05 to about 10% by weight of the epoxy resin. The epoxy composition may contain more than one catalyst.

The type and amount of catalyst present will affect the cure rate, which can affect moldability. For example, if the amount of the specific catalyst chosen is too large, the material may cure too rapidly and set before filling the mold, leading to poor spiral flow performance. Therefore, if a formulation that contains the desired amount of composite particles exhibits spiral flow measurements that are too low to be effectively compensated with liquid silicon-containing compound, lowering the amount of catalyst can improve flow. If lowering the catalyst level does not sufficiently improve the flow without unacceptably extending the cure time, the amount of composite polymer particles in the formulation may need to be reduced. Alternatively, the amount of inorganic filler, if present, may be lowered to increase flow; however, the amount of filler removed should not be sufficient to degrade other key properties such as thermal expansion.

Mold release agents are useful to prevent sticking of the composition in the mold and provide easy release therefrom after a molding operation. Waxes such as carnauba, montan, and various silicones, polyethylenes and fluorinated compounds may be employed. Certain metallic-fatty acid compounds such as zinc, magnesium and calcium stearates, as well as glyceryl-fatty acid compounds, are also useful. Other lubricants may be used where deemed necessary, although in some molding preparations it may not be necessary to incorporate a mold release agent in the epoxy composition itself.

The most widely used pigment or coloring agent for epoxy molding compositions is carbon black. As is readily understood, a great variety of pigments other than carbon black may be employed, as desired, for special coloring effects. Pigments which also serve as flame retardants include the metal-containing compounds where the metal is antimony, phosphorus, aluminum and bismuth. Organic halides are also useful for providing flame retardancy.

Coupling agents may also be used to improve water resistance or the wet electrical properties of the molding composition. Preferred coupling agents are silanes, for example the silanes commercially available from Dow Corning Corporation under the designations "Z-6040"- Gamma-glycidoxypropyltrimethoxysilane, and "Z-6070"- Methyl-trimethoxysilane. Silanes are also available from Union Carbide Corporation under the following designations: A-162-Methyl-triethyoxysilane; A-163-Methyl-trimethoxysilane; A-172-Vinyl-tris-(2-methoxyethoxy)silane; A-186-Beta-[3,4 epoxy-cyclohexyl]ethyltrimethoxysilane; A-187-Gamma-glycidoxypropyltrimethoxysilane; and A-1100-Gamma-aminopropyl- triethoxysilane. Also useful are: KBM-202-Diphenyldimethoxysilane - available from SHINETSU CHEMICAL CO., and PO-330-Phenyltrimethoxysilane - available from PETRARCH SYSTEMS, INC. When used, the quantity of coupling agent employed is preferably from about 0.05 to about 3 percent by weight, based on epoxy molding composition.

The epoxy compositions of the invention may be prepared by mixing and blending the component materials, for example in a ball mill, and then optionally compacting the blend for ease of handling. If desired, the blend can be pre-mixed and melt processed in an extruder. The blend may be fed by any suitable means, such as a conveyor, to a differential roll mill which comprises a hot roller and a cold roller spaced between one and six millimeters apart along their lengths. This separation is known as the nip. The nip can be adjusted to obtain sheet of the desired dimension.

The differential roll mill may be any such mill known in the art. In general, the rollers of the mill are rotated in opposite directions at different surface velocities about their respective longitudinal axes which are approximately horizontally disposed. In general, the relative rotational speeds of the rollers are at a ratio of from 1.1:1 to 1.3:1 and the rotational speed of the hot roller is generally from about 10 to 30 rpm. The rollers are rotationally mounted on a suitable support by any suitable bearing means.

Examples of such suitable bearing means are roller bearings, ball bearings and sleeve bearings. The support means may be a frame or any structural component attached to a building or the earth. The rollers are rotated by any suitable rotating means, such as an electric motor or a steam engine, connected to acentral shaft on the roller by any suitable means such as a chain, a belt orgears. In general, positive drive mechanisms such as chains or gears are preferred.

The surface temperature of the hot roller in general is near the melting temperature of the resin in the blend, i.e., within about 20 degrees C. of the melting temperature of the resin, but is at a temperature insufficient to cure the resin within the residence time of the blend on the hot roller of the mill. Usually, the surface temperature of the hot roll is from 65° to 120° C. and is maintained by any suitable heating means or mechanism such as hot water circulating through the hot roller or an electrical heating element. The hot roll temperature may be as high as 130° C. for some special resins.

The present invention will now be further illustrated by way of the following tests which are for illustrative purposes only and are not to be construed as imposing any limitation on the scope of the invention. In the tests, Examples 1 to 8 are examples according to the invention.

<u>TESTS:</u>

TEST METHODS

Kras Flash and Bleed Test

This method is used to determine the flash and resin bleed tendencies of a molding compound using a KRAS Corp. multichannel mold with channel depths of 0.076, 0.051, 0.025, 0.013, and 0.0064 mm (3.0 mil, 2.0 mil, 1.0 mil, 0.5 mil, 0.25 mil) and a transfer molding press capable of maintaining a transfer pressure of at least 10.343 MPa (1500 psi), a clamp pressure of at least 17.238 MPa (2500 psi), and temperatures up to 200°C (392°F). Tests were conducted at a mold temperature of 175 degrees C and a pressure of 6.895 MPa (1000 psi).

Spiral Flow (EMMI) and Ram Follower Gel Time of Epoxy Molding Compounds

This method measures the flow and gel characteristics of thermosets, using a transfer molding press equipped with a transfer pot diameter of 4.45 cm (1.75 inches); an EMMI spiral flow mold; and a Ram-following device which consists of a Demodulator-regulator model CAS-025 from Schaevitz Engineering, Camden, New Jersey or equivalent; an A.C. Transducer-core and coil-model 500 HR linear variable differential transformer having a linear travel range of 2.54 cm (1.0 inch), or 1.27 cm (0.5 inch) on either side of a central zero point, from Schaevitz Engineering or equivalent and a Recorderany millivolt, strip chart recorder such as Texas Instruments Inc., Servo-riter II portable recorder, Model PSD, IW6 or Brown potentiometer, class 15. The recorder must be a two channel pen type which prints out two continuous lines.

The ram follower device transmits to the chart recorder the increased flow rate as the molding compound melts , and subsequently the decrease in flow rate as viscosity builds due to resin polymerization. Thus it indicates the gelation time of the compound, the point where the material ceases to flow.

The press platen temperature controllers are set to yield 175 ± 3°C mold temperature and the transfer ram pressure is set to 6.895 MPa absolute (1000 psia). The transfer ram speed was set in the range of 2.54 to 10.16 cms (1 to 4 inches) per second. Granular sample is added to the transfer pot to give 3.05 to 3.56 mm (0.12 to 0.14 inches) cull thickness and the transfer cycle is activated. The sample is allowed to cure for at least 90 seconds. The mold is opened and the part of the farthest continuous flow is measured and recorded. The flow curve obtained from the strip chart indicates the gel time, in seconds.

Stress Test:

Unless otherwise stated, the test was ASTM F-100 stress test.

MATERIALS:

Composite particles

An emulsion of composite particles was prepared according to the teachings of US-A-3,761,455 and US-A-3,775,514 which are herein incorporated by reference. The first stage" a", which represents 75 percent of the total polymer particle composition, was prepared by polymerizing butadiene monomer and 1 percent by weight of divinylbenzene crosslinker. The second stage "b" which is 16.7 percent of the total polymer composition, contains 85 parts styrene per 15 parts methylmethacrylate and 2 percent of divinylbenzene crosslinker based on the combined amount of styrene and methylmethacrylate in stage "b". The third stage "c" which is 8.3 percent of the total composition, is methylmethacrylate and 2 weight percent divinylbenzene crosslinker based on the methylmethacrylate in stage "c". The resulting composite polymer particles were used in the following examples.

Liquid Silicon-containing Compounds-

X-3037 methoxy functional silicone intermediate available from Dow Corning Corporation; and Silwet L-7500 available from Union Carbide Corporation.

## TEST A

Stress Reduction with Composite Particles:

A series of epoxy formulations were prepared according the following basic formulation.

| | Ingredient | grams |
|---|---|---|
| Epoxy | | |
| | ESCN-195XL-25-(Sumitomo Chemical) | 142.47 |
| Hardener | | |
| | BRWE-5555 phenolic novolac-(Union Carbide Corporation) | 68.04 |
| Catalyst | | |
| | Benzyl-dimethyl-amine | 1.80 |
| Flame retardants | | |
| | Antimony trioxide<br>tetrabromo-bisphenol-A | 9.45<br>16.47 |
| Lubricants | | |
| | glycerol monostearate<br>calcium stearate<br>AC-1702 polyethylene wax-Allied Chemical<br>Carnauba Wax | 1.35<br>1.80<br>0.72<br>1.62 |
| Pigment | | |
| | carbon black | 2.25 |
| Coupling agent | | |
| | A-187 silane (Union Carbide Corporation) | 3.60 |
| Filler | | |
| | fused silica (200 mesh)<br>fused silica (325 mesh)<br>Aerosil R-972 | 310.68<br>330.75<br>9.0 |

The unmodified epoxy formulation was used as the control. Three modified samples were prepared by adding increasing amounts of the composite particles, prepared as above, to the control, as a weight/weight replacement for part of the fused silica filler. The compositions were ground in a ball mill to achieve thorough mixing. The percent stress reduction was calculated based on the coefficient of thermal expansion and the modulus of the materials.

The samples containing the composite polymer particles produced stress reduction but exhibited decreased spiral flow and decreased gel time versus the control.

## TEST B

Effect of Liquid Silicon-containing Compound:

A series of epoxy formulations were prepared according the following basic formulation.

| | Ingredient | grams |
|---|---|---|
| Epoxy | | |
| | ESCN-195XL-25-(Sumitomo Chemical) | 142.47 |
| Hardener | | |
| | BRWE-5555 phenolic novolac-(Union Carbide Corporation) | 68.04 |
| Catalyst | | |
| | Benzyl-dimethyl-amine | 1.80 |
| Flame retardants | | |
| | Antimony trioxide | 9.45 |
| | tetrabromo-bisphenol-A | 16.47 |
| Lubricants | | |
| | glycerol monostearate | 1.35 |
| | calcium stearate | 1.80 |
| | AC-1702 polyethylene wax-Allied Chemical | 0.72 |
| | Carnauba Wax | 1.62 |
| Pigment | | |
| | carbon black | 2.25 |
| Coupling agent | | |
| | A-187 silane (Union Carbide Corporation) | 3.60 |
| Filler | | |
| | fused silica (200 mesh) | 310.68 |
| | fused silica (325 mesh) | 330.75 |
| | Aerosil R-972 | 9.0 |

The unmodified epoxy formulation was used as the control. Modified samples were prepared by adding, to the above formulation, a liquid silicon-containing compound, (Dow Corning X-3037 methoxy functional silicone intermediate), as a weight/weight replacement for part of the fused silica filler. The amount added is indicated in the table below as a percent of the total composition by weight. The compositions were ground in a ball mill to achieve thorough mixing. Compositions containing the added siloxane fluid displayed increased resin bleed versus the control in the Kras Flash and Bleed Test and the degree of resin bleed increased as the level of liquid silicon-containing compound increased. The experimental sample (Example 1) was modified with 1.5% by weight X-3037 and 3.17% by weight of the composite particles prepared as above. This sample displayed a lower degree of resin bleed than the control, however spiral flow was lower than desired.

| KRAS FLASH AND BLEED TEST | | | | |
|---|---|---|---|---|
| Test Formulations | 0.076 mm (3.0 mil) | 0.051 mm (2.0 mil) | 0.025 mm (1.0 mil) | 0.013 mm (0.5 mil) |
| Control | 79.43 | 13.59 | 2.91 | 1.47 |
| 1.5% X-3037 | 17.17 | 13.26 | 6.21 | 3.95 |
| 2.0% X-3037 | 12.17 | 10.30 | 4.68 | 5.09 |
| Example | 25.04 | 14.37 | 2.34 | 0.81 |

## TEST C

A series of epoxy formulations were prepared containing the following ingredients in the amounts stated. The compositions were ground in a ball mill to achieve thorough mixing.

| Ingredient | grams |
|---|---|
| Epoxy | |
| ESCN-195XL-25-(Sumitomo Chemical) | 144.01 |
| Hardener | |
| BRWE-5555 phenolic novolac-(Union Carbide Corporation) | 70.45 |
| Catalysts | |
| Benzyl-dimethyl-amine<br>Adduct of Triphenylphosphine and Benzoquinone (Equimolar) | 1.53<br>1.80 |
| Flame retardants | |
| Antimony pentoxide<br>tetrabromo-bisphenol-A | 9.33<br>12.52 |
| Lubricants | |
| glycerol monostearate<br>calcium stearate<br>AC-1702 polyethylene wax-Allied Chemical<br>Carnauba Wax | 1.35<br>1.80<br>0.72<br>1.62 |
| Pigment | |
| carbon black | 2.25 |
| Filler | |
| fused silica (200 mesh)<br>fused silica (325 mesh) | 310.61<br>330.67 |
| Coupling agent | |
| A-187 silane (Union Carbide Corporation) | 3.60 |

Composite particles, prepared as above, were added to the formulation in the amounts stated in the table below, the amounts being indicated as a percent of the total composition by weight. The composite particles were added as a weight/weight replacement for part of the fused silica filler.

The experimental samples (Examples 2 and 3) were prepared by modifying the above formulation by adding a liquid silicon-containing compound, Dow Corning X-3037 methoxy functional silicone intermediate,

as a weight/ weight replacement for part of the fused silica filler. The amount added is indicated in the table below as a percent of the total composition by weight. The compositions were ground in a ball mill to achieve thorough mixing.

| Low Stress Additive | | | |
|---|---|---|---|
| System Component | | Example Number | |
| | C | Ex.2 | Ex.3 |
| Composite particles | 3% | 3% | 2% |
| X-3037 intermediate | ---- | 3% | 2% |

The spiral flow, gel time and F-100 Stress test ratings of these formulations are set forth below.

| Sample | Spiral Flow cm (in) | Gel.t (sec.) | F-100 Stress |
|---|---|---|---|
| C | 50.29 (19.8) | 13.3 | 2210 |
| Ex.2 | 138.43 | 19.5 | 1766 |
| Ex.3 | 100.33 (39.5) | 20 | 2026 |

The samples that contained the low stress additive system displayed better spiral flow and gel time ratings than the sample that contained only the composite particles as additive.

## TEST D

Mixtures of Liquid Silicon-containing Compounds Can be Used with Varying Levels of the Composite Particles:

A series of epoxy formulations were prepared containing the following ingredients in the amounts stated. The compositions were ground in a ball mill to achieve thorough mixing.

| Ingredient | grams |
|---|---|
| Epoxy | |
| ESCN-195XL-25-(Sumitomo Chemical) | 295.18 |
| Hardener | |
| BRWE-5555 phenolic novolac-(Union Carbide Corporation) | 132.35 |
| Catalysts | |
| Benzyl-dimethyl-amine<br>Triphenylphosphine | 2.75<br>4.25 |
| Flame retardants | |
| Antimony pentoxide<br>tetrabromo-bisphenol-A | 46.28<br>62.08 |
| Lubricants | |
| glycerol monostearate<br>calcium stearate<br>AC-1702 polyethylene wax-Allied Chemical<br>Carnauba Wax | 3.75<br>5.00<br>2.00<br>2.50 |
| Pigment | |
| carbon black | 6.25 |
| Filler | |
| fused silica (200 mesh) | 1801.67 |
| Coupling agent | |
| A-187 silane (Union Carbide Corporation) | 10.00 |

The amount of each component of the low stress additive system of the invention was varied as shown in the following table, and was added as a replacement for part of the filler. Amounts are expressed as a percentage by weight of the total composition.

| Low Stress Additive | | | | | |
|---|---|---|---|---|---|
| System Component | Example Number | | | | |
| | 4 | 5 | 6 | 7 | 8 |
| Composite particles<br>X-3037 intermediate<br>Silwet L-7500 | 2.510<br>1.04<br>0.48 | 3.766<br>1.04<br>0.48 | 3.138<br>1.30<br>0.60 | 2.510<br>1.56<br>0.72 | 3.766<br>1.56<br>0.72 |

The spiral flow, gel time and Kras Flash and Bleed performance of these formulations were evaluated at a mold temperature of 175 degrees C and mold pressure of 6.895 MPa (1000 psi), and are reported below.

| Kras Flash and Bleed Test | | | | | | | | |
|---|---|---|---|---|---|---|---|---|
| | Spiral Flow cm (in.) | Gel.t (sec.) | 0.076 mm (3 mils) | 0.051 mm (2 mils) | 0.025 mm (1 mils) | 0.013 mm (0.5 mils) | 0.0064 (0.25 mil) | F-100 Stress |
| Example 4 | 69.34 (27.3) | 17 | 73.82 | 2.23 | 0.54 | 0.58 | 0.64 | 2371 |
| Example 5 | 58.17 (22.9) | 18 | 73.60 | 2.12 | 0.52 | 0.56 | 0.55 | 2097 |
| Example 6 | 79.5 (31.3) | 17 | 73.81 | 2.09 | 0.56 | 0.63 | 0.78 | 2169 |
| Example 7 | 89.15 (35.1) | 15 | 74.02 | 1.53 | 0.52 | 0.56 | 0.55 | 2220 |
| Example 8 | 84.33 (33.2) | 18 | 73.64 | 1.55 | 0.49 | 0.52 | 0.55 | 959 |

The above data demonstrate the desirable spiral flow and low resin bleed performance of an epoxy formulation modified with varying amounts of the components of the low stress additive system of the invention. This data also demonstrates that combinations of liquid silicon-containing compounds can be used. All formulations had ASTM F-100 stress test ratings below a typical, though not identical, commercial epoxy formulation Plaskon 3400 which had a relative F-100 stress test rating of about 2500.

## Claims

1. A low stress additive system for lowering the internal stress of epoxy molding compositions, which comprises:
    (a) an amount of composite organic polymer particles effective to provide the desired reduction of the internal stress of the cured epoxy molding composition, the composite organic polymer particles having a soft rubbery core of organic polymer and at least one shell of harder organic polymer; and
    (b) an amount of liquid silicon-containing compound, other than silane coupling agents, effective to maintain flowability of the epoxy without causing substantially increased resin bleed.
2. A low stress additive system as claimed in claim 1, wherein the liquid silicon-containing compound is an organopolysiloxane, for example methoxy-functional reactive silicone intermediate, or polyalkylene-oxide functional organopolysiloxane.
3. A low stress additive system as claimed in claim 1 or claim 2, wherein the composite polymer particles are methacrylate-butadiene-styrene polymer particles.
4. An epoxy encapsulant composition, which comprises epoxy resin and a low stress additive system as claimed in any of claims 1 to 3 and wherein the amount of the composite organic polymer particles is from about 0.1 to about 20 percent by weight of the total composition, and the amount of the liquid silicon-containing compound is from about 0.1 to about 10 percent by weight of the total composition.
5. An epoxy encapsulant composition as claimed in claim 4, wherein the epoxy resin is selected from glycidyl ethers of bisphenol A, glycidyl ethers of phenolformaldehyde resins, and aliphatic, cycloaliphatic, aromatic and heterocyclic epoxies.
6. An epoxy encapsulant composition as claimed in claim 4 or claim 5, wherein the epoxy resin is present in an amount of from about 5 to about 80 percent by weight, based on the total weight of the composition.
7. An epoxy encapsulant composition as claimed in any of claims 4 to 6, wherein the composite organic particles are present in an amount of from about 1 to about 5 weight percent, based on the total weight of the composition.
8. An epoxy encapsulant composition as claimed in any of claims 4 to 7 which further comprises one or more of hardeners, catalysts, mold release agents, pigments, flame retardants and coupling agents.
9. An electronic device encapsulated in an epoxy composition as claimed in any of claims 4 to 8, or an epoxy composition comprising a low stress additive system as claimed in any of claims 1 to 3.
10. Improved electronic equipment comprising an electronic device as claimed in claim 9.